# EUROPEAN PATENT SPECIFICATION

(11) **EP 0 423 721 B1**
(45) Date of publication and mention of the grant of the patent: **27.03.1996**
(21) Application number: 90119834.1
(22) Date of filing: 16.10.1990
(51) Int. Cl.: H01L 29/32, H01L 29/74, H01L 31/111, H01L 29/72, H01L 29/78, H01L 21/263

(54) **Semiconductor device with overvoltage protective function and method of fabricating such device**
Halbleiteranordnung mit Überspannungsschutzvorrichtung und Verfahren zu ihrer Herstellung
Dispositif semi-conducteur comportant un arrangement de protection contre les surtensions et méthode de fabrication correspondante

(30) Priority: 16.10.1989 JP 268783/89
(43) Date of publication of application: 24.04.1991
(73) Proprietor: KABUSHIKI KAISHA TOSHIBA, Kawasaki-shi, Kanagawa-ken 210, Tokyo (JP)
(72) Inventor: Kitagawa, Mitsuhiko, Intellectual Property Div., Minato-ku, Tokyo 105 (JP); Tsunoda, Tetsujiro, Intellectual Property Div., Minato-ku, Tokyo 105 (JP); Osawa, Akihiko, Intellectual Property Div., Minato-ku, Tokyo 105 (JP)
(74) Representative: Lehn, Werner, Dipl.-Ing.

(56) References cited:
- EP-A- 0 316 881
- EP-A- 0 343 369
- US-A- 4 314 266
- PATENT ABSTRACTS OF JAPAN, vol. 12, no. 196, (E-619)(3043) 7 June 1988 & JP-A-62 298 120

## Description

The present invention relates to a semiconductor device with overvoltage protective function and a method of fabricating such device, and more particularly to a semiconductor device having a better accuracy in the breakdown voltage of overvoltage protective mechanism such as power thyristors and IGBTs handling a high voltage and to a method of fabricating such device.

High capacity semiconductor devices for converting a high voltage, to which an overvoltage several times as large as rated voltage thereof is applied, are often broken down. Accordingly, semiconductor devices containing overvoltage protective function have been developed. Prior art will be explained taking thyristors with overvoltage protective function as an example. Overvoltage protective function is broadly classified into punch-through type and avalanche type.

Thyristors with punch-through type voltage protective function are described, for example, in the literature, Laser Trimming of Thyristors, IEEE PESC, '85, pp. 463 - 468. In the punch-through type, a recess is provided on a P gate base layer. When a forward blocking voltage (forward voltage in off state) is applied to a thyristor, a depletion layer is formed and spread near the junction of the P gate base layer and an N base layer, with the increase of the forward blocking voltage. When the forward blocking voltage is further increased to reach a breakdown voltage V_{BD} at which self protective function is performed, the depletion layer on the P gate base layer side reaches the recess to be punched through. This causes a flowing current to function as the gate current of a pilot thyristor and turn on the pilot thyristor, so that the amplified on-current of the pilot thyristor becomes the gate current of a main thyristor, whereby the main thyristor is safely turned on to cause the thyristor to be protected. The self protective breakdown voltage V_{BD} is selected to set a proper value less than the minimum overvoltage V_{BDM} which might break down the thyristor.

In the thyristors with punch-through type overvoltage protective function, for example, the thickness of the depletion layer extending to the P gate base is very narrow compared with that to the N base due to the concentration of the impurity in respective base layer, so that the accurate control of the self protective breakdown voltage V_{BD} in the course of fabrication is very difficult with respect to mass productivity even if it can be performed in a laboratory step.

Thyristors with avalanche type voltage protective function are described, for example, in the literatures, Photothyristors with Overvoltage Protective Function, ED85-4, pp. 23 - 29 Toshiba; Basic Characteristics of High-Voltage Withstand Self Protective Type Photothyristors, EDD-86-53, pp. 69 - 75, Hitachi; and Controlled Turn-on Thyristors, IEEE, Trans-Electron Devices, ED-30, pp. 816 - 824 (1983) GE.

In the avalanche type thyristors, provided on a part of the P gate base layer of a PNPN structure thyristor is a region in which avalanche breakdown is more liable to occur than in other parts. By the rising transient voltage V_{BD} (self protective breakdown voltage) of a destructive overvoltage, first the region is avalanche broken down, then a non-destructive avalanche current flows to the P gate base layer of a pilot thyristor, whereby the pilot thyristor and subsequently a main thyristor are turned on to attenuate the overvoltage, causing the thyristor to be protected.

The avalanche type thyristors is provide with a crook on the trigger light incident surface of the center thereof or on the junction directly under the gate electrode of the pilot thyristor. As known, the crook, on which electric field is concentrated, is more liable to occur avalanche breakdown than other parts. A desired self protective breakdown voltage V_{BD} is obtained by changing the curvature of the crook.

In the above conventional avalanche type thyristors, the gate base region, in which avalanche breakdown is performed, is formed in the course of element fabricating process, so that when the self protective breakdown voltage V_{BD} is measured upon the completion of the element, the breakdown voltage indicates inevitably varied values because of variation in material or process. Since the avalanche voltage has a positive temperature dependence, inevitably the breakdown voltage also has a temperature dependence. This means that the breakdown voltage at a high temperature becomes higher than at a normal temperature, so that the design of thyristors becomes severe, in particular, with respect to voltage-withstand and di/dt quantity-withstand.

A device having a main thyristor and an auxiliary thyristor according to the preamble of claim 1 is known from EP-A-0 316 881. The break-over voltage of the auxiliary thyristor is lowered by introducing a portion of the anode layer with an increased impurity concentration. In order to adjust the reduced break-over voltage of the auxiliary thyristor to higher values, a portion of the auxiliary thyristor is irradiated to produce crystal defects. This however causes a decreased amplication factor. It is also difficult to obtain the desired break-over voltage.

Document EP-A-0 343 369 which forms part of the state of the art as defined by Article 54(3)EPC, discloses a thyristor having a high-density crystal defect layer formed in the n-base adjacent the p-base. However, no auxiliary device in addition to the main thyristor is disclosed therein.

An object of the present invention is to provide a semiconductor device with overvoltage protective function and a method of fabricating such device which solves the above-described problems of semiconductor devices with overvoltage protective function, indicates a less variation of the self protective breakdown voltage V_{BD}, and can be mass produced with a yield and cost substantially equal to semiconductor devices without overvoltage protective function.

A semiconductor device according to the present invention is defined in claim 1.

Also, a method of fabricating semiconductor devices according to claim 15 of the present invention includes a process in which a specified region is irradiated with a radiant ray such as proton, heavy hydrogen, α-ray and an neutron to form a high-density crystal defect layer.

The high-density crystal defect layer formed by the irradiation with a radiant ray has features such as a good controllability of breakdown voltage and an easy limitation of formed region. The present invention utilizes such properties to solve the problems of prior arts.

The overvoltage protective function is a function to protect a semiconductor element from an excessive forward blocking voltage (forward voltage in off state). When an excessive forward blocking voltage (hereinafter simply referred to as an overvoltage) is applied to a semiconductor element without protective function, a breakdown occurs in an unspecified limited part. With the breakdown current in the unspecified limited part, in many cases, the part between main electrodes cannot be smoothly converted into turn on, so that the overcurrent due to overvoltage is concentrated on the vicinity of the unspecified limited part, causing the semiconductor element to be destroyed. The minimum destructive overvoltage is expressed as V_{BDM}.

The self protective breakdown voltage V_{BD} is previously determined in the design stage to be smaller than the voltage V_{BDM}, and a non-destructive breakdown voltage. The region in which a breakdown occurs by the voltage V_{BD} is a limited specified region.

In the present invention, the above-described specified regions include: (1) a region of a substrate which is out of the main current path, (2) a region located under a conductor electrode film (for example, the gate electrode film of the trigger step for thyristors) or a trigger light irradiation surface, (3) a region including the region in which a depletion layer is formed when a specified reverse voltage (self protective breakdown voltage V_{BD}) is applied to the PN junction blocking a forward voltage during off time, and (4) a region in which a higher density crystal defect than nearby regions exists.

When a destructive overvoltage is applied to a semiconductor device arranged as described above and then a transient voltage in the course of the rise of the overvoltage reaches the self protective breakdown voltage V_{BD}, a breakdown current flows through the specified region.

The overvoltage protective function utilizes the breakdown current and immediately attenuates or shuts off the destructive overvoltage to protect the semiconductor device.

In many devices such as thyristors, the breakdown current occurs in the high-density crystal defect of a specified region, that is, a control region (such as gate region and light trigger region) and becomes a gate current or a trigger current to turn on the part between main electrodes of a device, thereby causing a destructive voltage to be attenuated and the device to be protected.

On the other hand, a destructive voltage may be attenuated by a self protective breakdown current itself, or proper means for attenuating or shutting off the overvoltage may be provided outside the device and be controlled by the self protective breakdown current.

This invention can be more fully understood from the following detailed description when taken in conjunction with the accompanying drawings, in which:
Figs. 1 through 3 are sectional views of semiconductor devices of first through third embodiments according to the present invention;
Fig. 4 is a perspective view of a further semiconductor device;
Figs. 5 and 6 are sectional views of other semiconductor devices;
Figs. 7A and 7B are a perspective view and an electrically equivalent circuit diagram, respectively, of semiconductor device of a fourth embodiment according to the present invention;
Figs. 8A and 8B are a distribution graph of crystal defect density vs. substrate depth at the time of proton irradiation and a graph showing the relationship between the accelerated voltage and the stoppage depth of proton, respectively;
Figs. 9 and 10 are graphs showing the relationship between the dose quantity of proton irradiation and the voltage-withstand of diode;
Fig. 11 is a graph showing the relationship between the does quantity of proton irradiation and the self protective breakdown voltage V_{BD}; and
Figs. 12 and 13 are sectional views showing semi-conductor devices of fifth and sixth embodiments according to the present invention.

In a semiconductor device with overvoltage protective function according to the present invention, a high-density crystal defect layer is formed by irradiation with a radiant ray, thereby reducing the variation of the self protective breakdown voltage which is a problem to be solved. First, the basis of the fact will be explained hereinafter.

In the prior art, it has been experimentally known that when a semiconductor substrate is irradiated with a beam (radiant ray) such as proton (H⁺), a crystal defect layer is formed, in which layer a donor (acceptor) due to crystal defect occurs, and the life time of a carrier becomes short to cause the breakdown voltage to be reduced (for example, W. Wondrak et al., ISPSD, 1988, Tokyo, pp. 147 - 152).

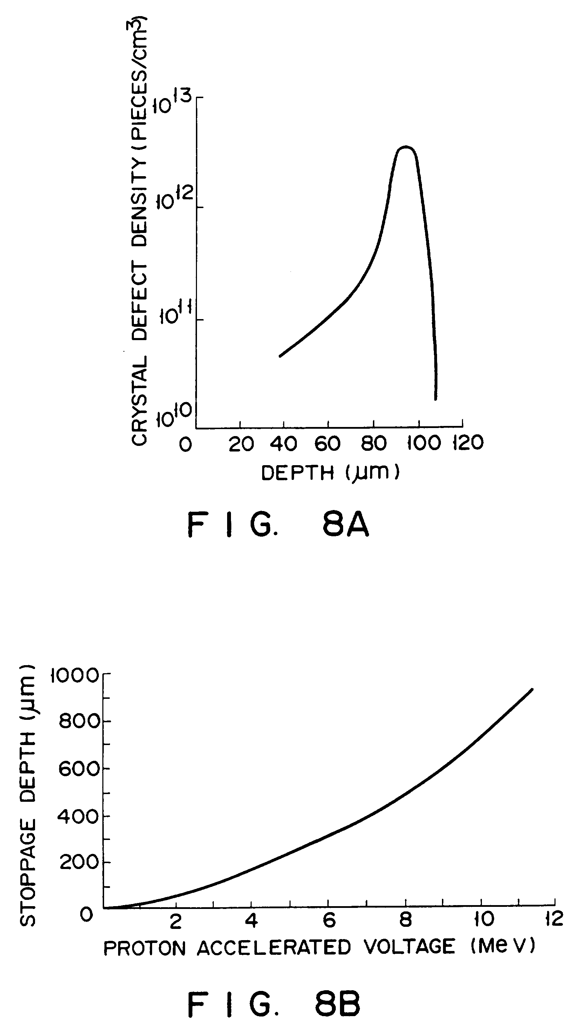

Fig. 8A shows a profile of crystal defect density vs. substrate depth when an N type Si substrate is irradiated by proton (H⁺) with a accelerated voltage of 3 MeV. The axis of ordinate represents a depth from the substrate (µm) and that of abscissa does a crystal defect density (pieces/cm³), and the curve in the graph indicates the defect density at respective depth. As shown in the graph, the defect density occurring by proton irradiation is concentrated on the place near the range of proton, that is, the place directly before the stoppage of proton particles. This means that a high-density crystal defect layer with a thickness limited in the depth direction can be formed by the irradiation of proton.

Fig. 8B is a graph showing the relationship between the accelerated voltage (MeV) and the stoppage depth (µm) of proton, which is obtained by calculation. Trial results reveal that when the accelerated voltage of proton is set to 10 MeV, a crystal defect layer is formed at the depth of about 700 µm beneath the Si substrate surface, showing good agreement with theory.

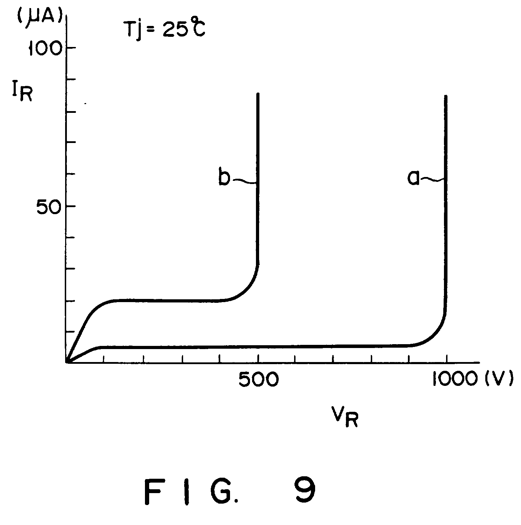

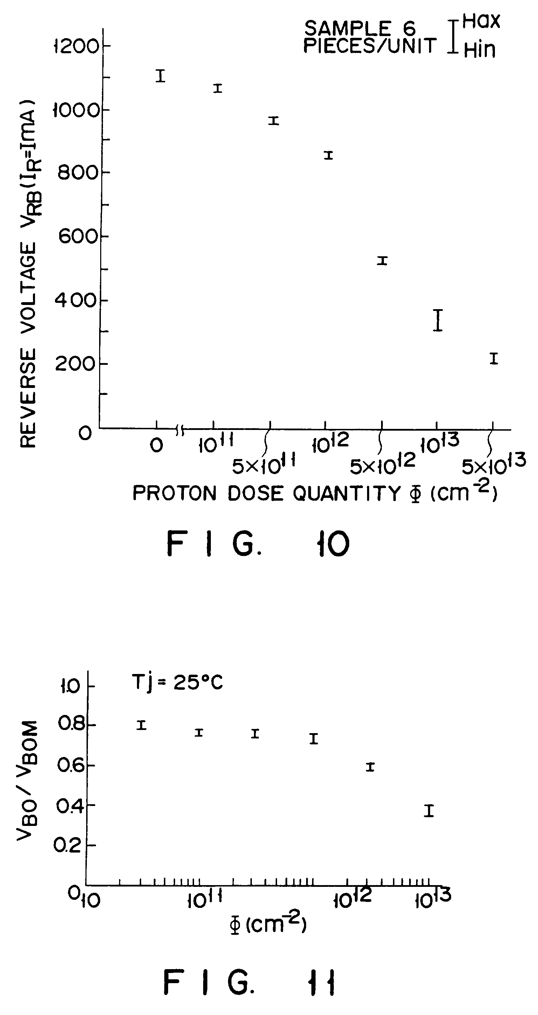

Figs. 9 and 10 are graphs showing the results of an experiment performed to obtain the relationship between the dose quantity of proton irradiation and the voltage-withstand of diode.

Fig. 9 shows the relationship between reverse voltage V_{R} and reverse current I_{R} flowing when the reverse voltage is applied to a PIN diode, that is, an example of V_{R} - I_{R} characteristics. In Fig. 9, the curve a, being for a diode not irradiated with proton, is broken down at about 1000 V. The curve b show an example of V_{R} - I_{R} characteristics measured after the N region of the diode is irradiated with proton with an accelerated voltage of 2 MeV and a dose quantity of 5 × 10¹ [cm⁻] to form a crystal defect layer. In this case, the diode is broken down at about 500 V. Fig. 10, showing a voltage-withstand characteristics, is the results of an experiment performed in a substantially similar method to that in Fig. 9. The axis of abscissa represents a dose quantity Φ [cm⁻] of proton irradiation, and the axis of ordinate does a reverse voltage V_{RB} [V] when a reverse current I_{R} increases to become 1 mA, which may be assumed to be substantially a breakdown voltage. The dose quantity of proton irradiation was allowed to change stepwise from Φ = 0 (when not irradiated) to 5 × 10¹³ [cm⁻]. Six specimens were used for each dose quantity, and the vertical short lines in the graph indicate the distribution range of the V_{BD} of the six specimens. The experimental results shown in Figs. 9 and 10 indicate that the reverse voltage V_{RB} of a diode, that is, the breakdown voltage of a PN junction can be controlled by changing the dose quantity of proton irradiation, and at that time the variation of the breakdown voltage is very little.

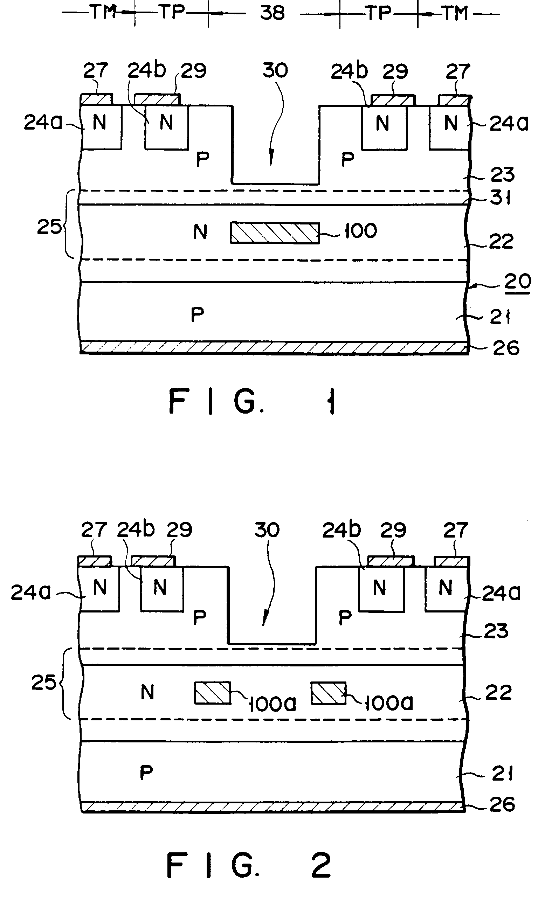

An embodiment in which the present invention is applied to a photothyristor will be explained hereinafter. Fig. 1 is a typical sectional view near the center of such thyristor. On a semiconductor substrate 20, a main thyristor TM consisting of a P emitter layer 21, an N base layer 22, a P gate base layer 23 and an N emitter layer 24a is formed, and a pilot thyristor TP surrounded with the main thyristor TM and consisting of the P emitter layer 21, the N base layer 22, the P gate base layer 23 and an N emitter layer 24b is formed. The region surrounded by the pilot thyristor TP is the gate region of the pilot thyristor TP, and provided with a phototrigger mechanism. The phototrigger mechanism comprises a first conductive type semiconductor layer (P gate base layer) 23 exposed to the main surface of the substrate (in this case, taken as the upper surface of the substrate), a trigger light irradiation surface 38 being the exposed surface of the P gate base layer including the inner surface of a recess 30, a second conductive type semiconductor layer (N base layer) 22 in contact with the underside of the P gate base layer 23, and the P emitter layer 21. In the photothyristor according to the present invention, a high-density crystal defect layer 100 is provided in a region 25 in which a depletion layer is formed when a reverse voltage substantially equal to the self protective breakdown voltage V_{BD} is applied to a PN junction 31 of the P gate base layer 23 and the N base layer 22. The sign 26 indicates an anode electrode, 27 does a cathode electrode of the main thyristor, and 29 does an amplification gate electrode (equivalent to a cathode electrode of the pilot thyristor). The graphic display of a passivation film and the like with which the main substrate surface is covered is omitted.

The operation of the above-described photothyristor will be explained hereinafter. When, with a forward blocking voltage applied between the anode electrode 26 and the cathode electrode 27, the trigger light irradiation surface 38 is irradiated by a trigger light, an excessive carrier due to photoexcitation occurs on the P gate base layer 23 and the N base layer 22 including the depletion layer under the irradiation surface 38. The pilot thyristor, particularly being of a high gate sensitivity structure, is turned on by the light gate current. Subsequently the turn-on current causes the main thyristor to be turned on, whereby the thyristor becomes on. The main current path of the thyristor is taken as the substrate region directly under the cathode electrode 27 through which the main part of a main current (on-current of the main thyristor) flows. Part of the main current extends horizontally and flows through the N base layer 22 directly under the pilot thyristor TP and the trigger light irradiation surface and through the P emitter layer 21. However, the ratio of the part of the main current is a little, so that the current path of the part is not included in the main current path in this embodiment.

A case where an accidental, destructive overvoltage is applied between the anode electrode 26 and the cathode electrode 27 of the thyristor in off state will be explained hereinafter. Generally, an overvoltage rises from a low voltage and reaches a destructive overvoltage. While a voltage applied is low, the voltage is blocked by the depletion layer of the PN junction 31, so that the thyristor is kept off. When the voltage applied is increased, the depletion layer expands and the electric field in the depletion layer becomes strong, and when the voltage reaches the self protective breakdown voltage V_{BD}, an avalanche breakdown occurs in a crystal defect layer 100, and the breakdown current flows through the anode electrode 26 and the amplification gate electrode 29 to the cathode electrode 27. The breakdown current, similarly to the above-described light gate current, becomes a gate current of the pilot thyristor TP, so that the pilot thyristor and subsequently also the main thyristor are turned on. This causes the overvoltage applied to the thyristor to be attenuated before reaching a destructive overvoltage, whereby the thyristor is protected from destroy.

The method of fabricating the above-described photothyristor is substantially the same as the prior art known fabricating method except for a process to form the crystal defect layer 100.

In the photothyristor (rated about 1000 V) of the present embodiment, the crystal defect layer 100 is formed by proton irradiation in the final process of element fabrication. At this time, the layer is irradiated from the anode side (underside of the substrate) with the accelerated voltage of proton being 10 MeV and the dose quantity 1 × 10¹³ cm⁻ or more. Used was a mask of proton beam which was an aluminum plate with a thickness of 700 µm or more and had an opening with an area substantially equal to the light trigger irradiation surface provided on the place under the substrate 22 and opposite to the irradiation surface.

The crystal defect layer formed thus is reduced in lift time corresponding to the defect density thereof, so that the position and extent of the layer as a low life time layer can be confirmed by the spreading resistance method or the DLTS (Deep Level Transient Spectroscopy). In the above-described embodiment, the peak of a crystal defect layer (called also a low breakdown layer or low life time layer) 100 existed in a depth of about 700 µm from the underside of the substrate.

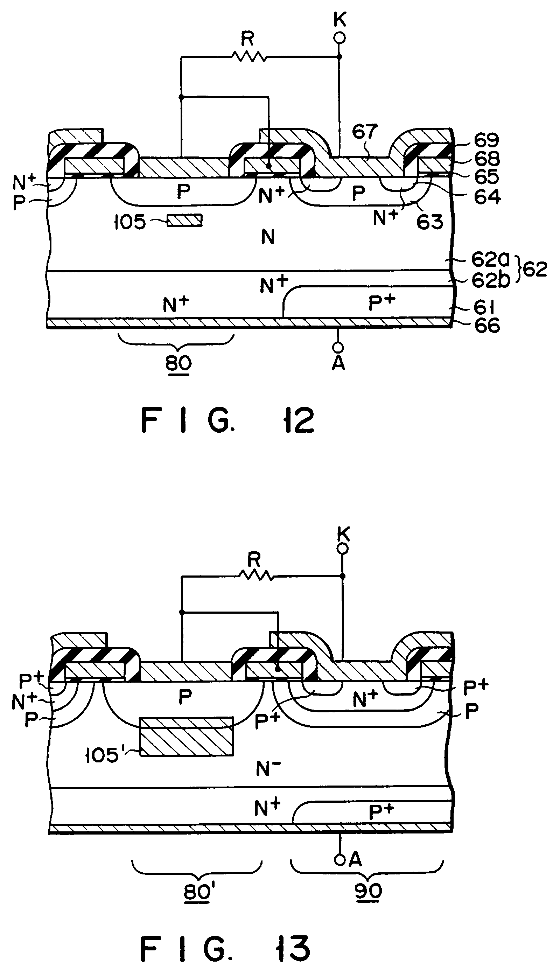

Then, thyristors having substantially the same structure as the photothyristor of the above-described embodiment and having the dose quantity of proton irradiation changed were prepared, and the respective self protective breakdown voltage V_{BD} was examined. Fig. 11 shows an example of the results. The axis of abscissa represents a dose quantity Φ [cm⁻] or proton irradiation, and the axis of ordinate does a normalized value (V_{BD}/V_{BDM}) of the self protective breakdown voltage V_{BD} based on the breakdown voltage V_{BDM} (6 KV) without proton irradiation. The accelerated voltage of proton is taken as 10 MeV, and the junction temperature Tj as 25°C. The vertical short lines in Fig. 11 indicate the distribution range of measured values. As shown in Fig. 11, the self protective breakdown voltage of a photothyristor can be accurately controlled by the dose quantity of proton irradiation.

It is preferable that the position of the crystal defect layer 100 in the depth direction is disposed in the depletion layer of the N base layer 22 nearer the junction 31 than the center of the N base layer. Care must be taken to confirm the position in the depth direction because, where a crystal defect layer is formed in the N base layer, the characteristics in the reverse direction of a thyristor, particularly the breakdown voltage in the reverse direction may vary depending on the position in the depth direction. Generally, a crystal defect layer can be formed in the position including part of the region in which a depletion layer is formed, or in a depletion layer across the junction 31. Although the proton irradiation from the underside of the substrate was performed in the present embodiment, the irradiation from the top side of the substrate may be performed. Although proton irradiation can be performed in the course of the process of element fabrication, it is preferable that it is performed in the final process of a wafer process as shown in the present embodiment. The self protective breakdown voltage is easily controlled, and an addition of dose quantity or redoing of irradiation can be performed.

Fig. 2 shows a second embodiment according to the present invention. The same sign as in Fig. 1 indicates the same part, so that the explanation on that part may be omitted. The thyristor in the second embodiment is different from the photothyristor shown in Fig. 1 in the shape of the crystal defect layer. That is, the crystal defect layer 100a is made a ring-shape layer having an opening directly under the base of the recess of the trigger light irradiation surface 38, and is an example in which the decrease of the light gate current in normal operation is prevented.

Having described photothyristors as an embodiment, the present invention can be applied to usual electric trigger thyristors and also to thyristors without a pilot thyristor.

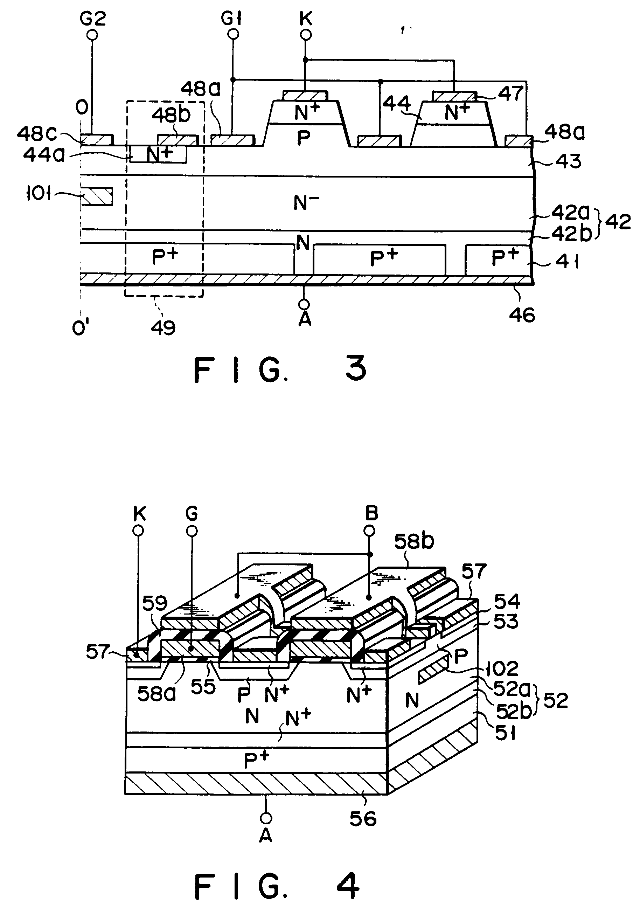

With reference to Fig. 3, a third embodiment in which the present invention is applied to a GTO will be explained hereinafter. Fig. 3 is a typical sectional view in the radius direction including the center axis 00′ perpendicular to the main surface of the GTO according to the present invention. The GTO comprises a P⁺ emitter layer 41, an N base layer 42, a P gate base layer 43 and an N⁺ emitter layer 44. The N base layer 42 is composed of a lamination of an N⁻ base layer 42a and a N base layer 42b, and part of the N base layer 42b extends to the underside of the substrate and is shorted to the P⁺ emitter layer 41 by an anode electrode 46 to form a so-called emitter short-circuit structure. The N⁺ emitter layer 44 is formed on the island-shape mesa base on the top side of the substrate, and provided with a cathode electrode 47. A gate electrode (terminal G₁) 48a is formed in such a manner as to surround the N+ emitter layer 44. The present GTO, to which an amplification gate structure 49 surrounded with broken lines is further added, is called a so-called GTO with amplification gate. The amplification gate structure 49, to which an N⁺ emitter layer 44a and an amplification gate electrode 48b are added, amplifiers on-gate signals inputted from a gate electrode (terminal G₂) 48c. The gate terminal G₁ is connected through a diode and the like (not shown) to the gate terminal G₂. The sign 101 indicates a high-density crystal defect layer according to the present invention, which is provided on a specified place of the N⁻ base layer 42a under the conductor electrode film (gate electrode) 48c.

Also, the present invention can undoubtedly be applied to a GTO without amplification gate structure.

Fig. 4 is a perspective view of a MOS control thyristor. The thyristor section is composed of a P⁺ emitter layer 51, an N base layer 52 consisting of an N layer 52a and an N⁺ layer 52b laminated with each other, a P base layer 53 and an N⁺ emitter layer 54. The MOS structure is composed of a surface layer (channel forming layer) of the P base layer 53 put between the N base layer 52 and the N⁺ emitter layer 54 and exposed to the substrate surface, a gate oxidation film 55 and a gate electrode 58a. Further, provided is a base electrode 58b in contact with the part of the P base layer 53 surrounded with the N⁺ emitter layer 54. The base electrode 58b is provided to improve mainly the off-characteristics of the thyristor. A high-density crystal defect layer 102 is provided on a specified place of the N base layer 52a under the conductor electrode film (base electrode) 58b. The signs 56 and 57 indicate an anode electrode and a cathode electrode, respectively, and the signs A, K, G and B indicate respective terminals of anode, cathode, gate and base, respectively. Also, the sign 59 indicates an interlayer insulation layer between the cathode electrode 57 and the gate electrode 58a.

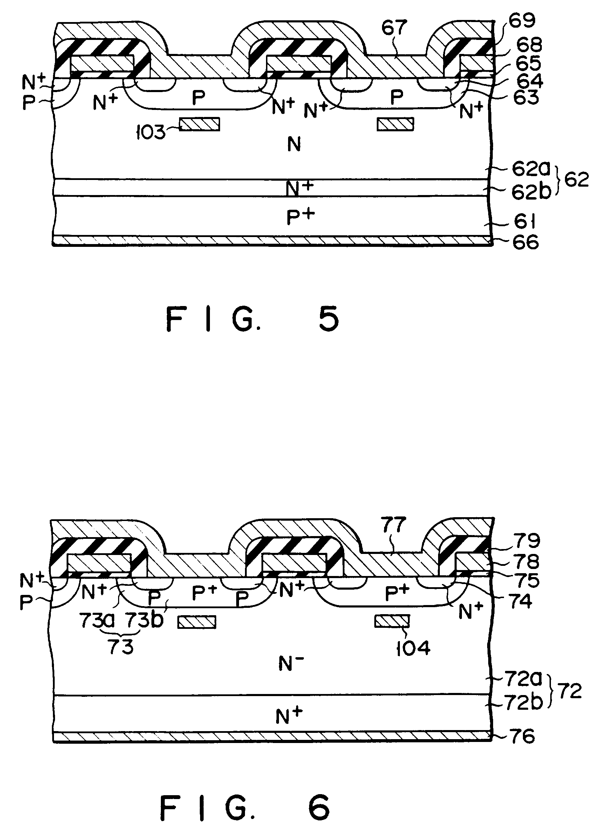

Fig. 5 is a typical sectional view of an insulation-gate type bipolar transistor (hereinafter abbreviated as an IGBT). The structure has a P⁺ emitter layer (also called a collector layer) 61, an N drift layer 62 consisting of an N layer 62a and an N⁺ layer 62b, and a P base layer 63 formed from the main surface of one side. An N⁺ emitter layer 64 is formed in the base layer 63. A surface layer (channel forming layer) of the P base layer 63 put between the N⁺ emitter layer 64 and the N drift layer 62a is opposed through an oxidation film 65 to a gate electrode 68 to form a MOS structure. The P base layer 63 and the N⁺ emitter layer 64 become a structure shorted by a conductor electrode film (called a cathode or emitter electrode). The sign 69 indicates an interlayer insulation layer, and the sign 66 does an anode electrode (also called a collector electrode). A high-density crystal defect layer 103 according to the present invention is provided on a specified place of the N drift layer 62a under a conductorelectrode film 67 of the part in contact with the P base layer 63 surrounded with the N⁺ emitter layer 64.

Fig. 6 is a typical sectional view of a double diffusion vertical type N-channel MOSFET. The sign 72 indicates an N drain layer, which consists of a low-density N⁻ layer 72a and a high-density N⁺ layer 72b. The sign 73 indicates a P base layer, which consists of a low-density P base layer 73a and a high-density P⁺ base layer 73b. In the P base layer, a ring-shape N⁺ source layer 74 is formed surrounding the P⁺ base layer 73b. A surface layer of the P base layer 73a put between the N⁺ source layer 74 and the N⁻ drain layer 72a is called a channel forming layer. Through a gate oxidation film 75, a gate electrode 78 is provided opposite to the channel forming layer. A conductor electrode film (source electrode) 77 is provided in ohm contact with the N⁺ source layer 74 and the P⁺ base layer 73b. The sign 76 indicates a drain electrode, and the sign 79 does an interlayer insulation layer. A freewheeling diode is formed by the P⁺ base layer 73b and the N drain layer 72. Accordingly, the part in ohm contact with the P⁺ base layer 73b of the conductor electrode film 77 serves also as an anode electrode of the freewheeling diode. A high-density crystal defect layer 104 is provided on a specified place of the N⁻ drain layer 72a under the anode electrode of the freewheeling diode.

When, in the devices of figures 3 through 6, an excessive forward blocking voltage is applied between the anode (drain) and the cathode (emitter) of each device and a transient voltage in the course of the rise of the overvoltage reaches the self protective breakdown voltage, an avalanche breakdown occurs in the high-density crystal defect layer, whereby a breakdown current flows, the device is turned on and the overvoltage is attenuated, with the result that the device is protected.

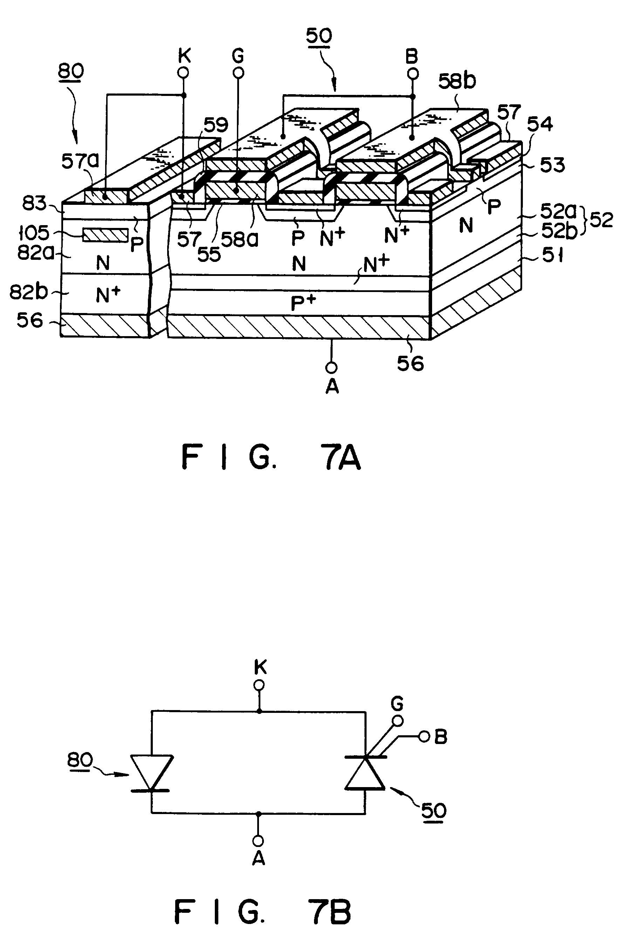

Figs. 7A and 7B show a fourth embodiment according to the present invention. In the present device, a self protective diode 80 is provided in reverse polarity between a cathode electrode 57 and an anode electrode 56 of a MOS control thyristor 50. Fig. 7A is a perspective view of the device, and Fig. 7B is an electrically equivalent circuit diagram. The same sign as in Fig. 4 indicates the same part. The self protective diode 80 is formed by laminating a conductor electrode film 57a, a P layer 83, an N layer 82a, an N⁺ layer 82b and the electrode film 56. A high-density crystal defect layer 105 according to the present invention is provided on a specified place of the N layer 82a under the conductor electrode film 57a. The conductor electrode film 57a and the N layer 82a can be formed in the same body together with the cathode electrode 57 and the anode electrode 56 of the MOS control thyristor 50.

When the self protective diode 80 is reverse biased by an overvoltage and reaches the self protective breakdown voltage V_{BD}, a high-density crystal defect layer develops an avalanche breakdown, causing the diode 80 to be broken down. The self protective breakdown current causes the overvoltage to be attenuated and the thyristor 50 to be protected. At this time, though not shown, with proper overvoltage attenuation means or overvoltage shut-off means provided outside the device, the means may be controlled by the above-described self protective breakdown current.

Although the fourth embodiment uses the MOS control thyristor 50 as an example, the present invention can also be applied to other power semiconductor devices such as thyristors, IGBTs, GTOs, MOSs and FETs.

Figs. 12 and 13 are sectional views showing semiconductors in an fifth and a sixth embodiments according to the present invention.

The fifth embodiment shown in Fig. 12 has a structure in which the IGBT shown in Fig. 5 is combined with the protective diode 80 shown in Fig. 7A and the same sign as the preceding embodiments is assigned to the same part.

Also, the sixth embodiment shown in Fig. 13 has a structure in which a protective diode 80' is combined with a MOS control thyristor 90 having a turn-off channel instead of the IGBT in the fifth embodiment. However, a crystal defect layer 105' of the protective diode 80' in the embodiment exists across the PN junction.

Besides the above-described embodiments, the present invention can be applied to semiconductor devices requiring another overvoltage protective mechanism such as SI thyristor.

## Claims

1. A semiconductor device with overvoltage protective function, comprising:
a first semiconductor layer (21) of a first conductivity type,
a second semiconductor layer (22) of a second conductivity type formed on said first semiconductor layer (21), and
a third semiconductor layer (23) of said first conductivity type formed on said second semiconductor layer (22),
wherein said semiconductor device includes a main device element (TM) having a main current path of the device, the main device element (TM) comprising a first part of said first, second and third semiccnductor layers (21, 22, 23), and an auxiliary device element (TP) comprising a second part of any two adjacent layers of said first, second and third semiconductor layers (21, 22, 23) outside said main current path, said second part being excluded from said first part;
**characterized** in that
a high-density crystal defect layer is formed only in an area of said auxiliary device element (TP), in which a depletion layer (25) is formed when a specified reverse voltage is applied to a PN-junction (31) between said two adjacent layers (22, 23) in said auxiliary device element (TP); and
said auxiliary device element (TP) is broken down prior to said main device element (TM), due to said high-density crystal defect layer (100), when an overvoltage is applied to said semiconductor device.

2. A semiconductor device according to claim 1, characterized in that said main device element (TM) is turned on by a breakdown current generated when said auxiliary device element (TP) is broken down.

3. A semiconductor device according to claim 1 or 2, characterized in that said two adjacent layers are said second and third semiconductor layers (22, 23), and said high-density crystal defect layer (100) is formed only in an area of said second semiconductor layer (22) in said auxiliary device element (TP), in which a depletion layer is formed when a specified-reverse voltage is applied to a PN-junction (31) between said second and third semiconductor layers (22, 23) in said auxiliary device element (TP).

4. A semiconductor device according to claim 3, characterized in that said auxiliary device element (TP) further comprises a second part of said first semiconductor layer (21) out of said first part.

5. A semiconductor device according to claim 1, 2 or 4, characterized in that said main device element (TM) further comprises a fourth semiconductor element (24a) of said second conductivity type formed on said third semiconductor layer (23), and said fourth semiconductor layer (24a) is not formed above said high-density crystal defect layer (100).

6. A semiconductor device according to claim 5, characterized in that said main device element (TM) constitutes a thyristor.

7. A semiconductor device according to claim 6, characterized in that said auxiliary device (TP) includes a gate region (38) formed on said third semiconductor layer (23).

8. A semiconductor device according to claim 7, characterized in that said gate region comprises a trigger light irradiation surface (38) which is the exposed surface of said third semiconductor layer (22).

9. A semiconductor device according to claim 8, characterized in that said trigger light irradiation surface (38) comprises a recess (30) formed in the third semiconductor layer (23).

10. A semiconductor device according to claim 7, characterized in that said gate region comprises a gate electrode (48c) in contact with said third semiconductor layer (43).

11. A semiconductor device according to anyone of the claims 1 to 10, characterized in that said crystal defect layer (100) is formed across the PN-junction (31) between said two adjacent layers in said auxiliary device element.

12. A semiconductor device according to anyone of the claims 7 to 10, characterized in that said crystal defect layer is a ring-shape layer (100a) having an opening directly under said gate region.

13. A semiconductor device according to anyone of the claims 1 to 5, characterized in that said main device element constitutes a transistor.

14. A semiconductor device according to claim 1, 2 or 3, characterized in that said auxiliary device element constitutes a diode.

15. A method of fabricating a semiconductor device according to anyone of the claims 1 to 14, characterized in that said high-density crystal defect layer (100) is formed by irradiation with a beam and a breakdown voltage of said auxiliary device element is controlled by the dose quantity of said irradiation.

16. The method according to claim 15, characterized in that the irradiation process with said beam is performed in the final process of semiconductor device fabrication.

17. The method according to claim 15, characterized in that said beam is selected from a group consisting of proton, helium and heavy hydrogen.

## Patentansprüche

1. Halbleitereinrichtung mit einer Überspannungsschutzfunktion, umfassend:
eine erste Halbleiterschicht (21) eines ersten Leitfähigkeits-Typs,
eine zweite Halbleiterschicht (22) eines zweiten Leitfähigkeits-Typs, die auf der ersten Halbleiterschicht (21) gebildet ist, und
eine dritte Halbleiterschicht (23) des ersten Leitfähigkeits-Typs, die auf der zweiten Halbleiterschicht (22) gebildet ist,
wobei die Halbleitereinrichtung umfaßt ein Haupteinrichtungselement (TM) mit einem Hauptstrompfad der Einrichtung, wobei das Haupteinrichtungselement (TM) einen ersten Teil der ersten, zweiten und dritten Halbleiterschichten (21, 22, 23) umfaßt, und ein Zusatzeinrichtungselement (TP), welches einen zweiten Teil von irgendwelchen zwei angrenzenden Schichten der ersten, zweiten und dritten Halbleiterschichten (21, 22, 23) außerhalb des Hauptstrompfads umfaßt, wobei der zweite Teil von dem ersten Teil ausgeschlossen ist;
**dadurch gekennzeichnet, daß**
eine Kristalldefektschicht mit hoher Dichte nur in einem Bereich des Zusatzeinrichtungselements (TP) gebildet ist, in dem eine Verarmungsschicht (25) gebildet ist, wenn eine bestimmte Sperrspannung an einen PN-Übergang (31) zwischen zwei angrenzenden Schichten (22, 23) in dem Zusatzeinrichtungselement (TP) angelegt ist; und
das Zusatzeinrichtungselement (TP) vor dem Haupteinrichtungselement (TM) durchbrochen wird, aufgrund der Kristalldefektschicht (100) mit hoher Dichte, wenn eine Überspannung an die Halbleitereinrichtung angelegt wird.

2. Halbleitereinrichtung nach Anspruch 1, dadurch gekennzeichnet, daß das Haupteinrichtungselement (TM) durch einen Durchbruchsstrom eingeschaltet wird, der erzeugt wird, wenn das Zusatzeinrichtungselement (TP) durchbrochen wird.

3. Halbleitereinrichtung nach Anspruch 1 oder 2, dadurch gekennzeichnet, daß die zwei angrenzenden Schichten die zweiten und dritten Halbleiterschichten (22, 23) sind, und die Kristalldefektschicht (100) mit hoher Dichte nur in einem Bereich der zweiten Halbleiterschicht (22) in dem Zusatzeinrichtungselement (TP) gebildet ist, in dem eine Verarmungsschicht gebildet wird, wenn eine bestimmte Sperrspannung an einen PN-Übergang (31) zwischen den zweiten und dritten Halbleiterschichten (22, 23) in dem Zusatzeinrichtungselement (TP) angelegt wird.

4. Halbleitereinrichtung nach Anspruch 3, dadurch gekennzeichnet, daß das Zusatzeinrichtungselement (TP) ferner einen zweiten Teil der ersten Halbleiterschicht (21) außerhalb des ersten Teils umfaßt.

5. Halbleitereinrichtung nach Anspruch 1, 2 oder 4, dadurch gekennzeichnet, daß das Haupteinrichtungselement (TM) ferner ein viertes Halbleiterelement (24a) des zweiten Leitfähigkeits-Typs umfaßt, das auf der dritten Halbleiterschicht (23) gebildet ist, und die vierte Halbleiterschicht (24a) nicht oberhalb der Kristalldefektschicht (100) mit hoher Dichte gebildet ist.

6. Halbleitereinrichtung nach Anspruch 5, dadurch gekennzeichnet, daß das Haupteinrichtungselement (TM) einen Thyristor bildet.

7. Halbleitereinrichtung nach Anspruch 6, dadurch gekennzeichnet, daß die Zusatzeinrichtung (TP) einen Gate-Bereich (38) umfaßt, der auf der dritten Halbleiterschicht (23) gebildet ist.

8. Halbleitereinrichtung nach Anspruch 7, dadurch gekennzeichnet, daß der Gate-Bereich eine Triggerlicht-Bestrahlungsoberfläche (38) umfaßt, die die freigelegte Oberfläche der dritten Halbleiterschicht (22) ist.

9. Halbleitereinrichtung nach Anspruch 8, dadurch gekennzeichnet, daß die Triggerlicht-Bestrahlungsoberfläche (38) eine Ausnehmung (30) umfaßt, die in der dritten Halbleiterschicht (23) gebildet ist.

10. Halbleitereinrichtung nach Anspruch 7, dadurch gekennzeichnet, daß der Gate-Bereich eine Gate-Elektrode (48c) in Kontakt mit der dritten Halbleiterschicht (43) umfaßt.

11. Halbleitereinrichtung nach einem der Ansprüche 1 bis 10, dadurch gekennzeichnet, daß die Kristalldefektschicht (100) über den PN-Übergang (31) zwischen den zwei angrenzenden Schichten in dem Zusatzeinrichtungselement gebildet ist.

12. Halbleitereinrichtung nach einem der Ansprüche 7 bis 10, dadurch gekennzeichnet, daß die Kristalldefektschicht eine ringförmige Schicht (100a) mit einer Öffnung direkt unter dem Gate-Bereich ist.

13. Halbleitereinrichtung nach einem der Ansprüche 1 bis 5, dadurch gekennzeichnet, daß das Haupteinrichtungselement einen Transistor bildet.

14. Halbleitereinrichtung nach Anspruch 1, 2 oder 3, dadurch gekennzeichnet, daß das Zusatzeinrichtungselement eine Diode bildet.

15. Verfahren zur Herstellung einer Halbleitereinrichtung nach einem der Ansprüche 1 bis 14, dadurch gekennzeichnet, daß die Kristalldefektschicht (100) mit hoher Dichte durch Bestrahlung mit einem Strahl gebildet wird und eine Durchbruchsspannung des Zusatzeinrichtungselements durch die Dosierungsgröße der Bestrahlung gesteuert wird.

16. Verfahren nach Anspruch 15, dadurch gekennzeichnet, daß der Bestrahlungsprozeß mit dem Strahl in dem letzten Prozeß einer Halbleitereinrichtungsherstellung durchgeführt wird.

17. Vefahren nach Anspruch 15, dadurch gekennzeichnet, daß der Strahl aus einer Gruppe gewählt wird, die aus Protonen, Helium und schwerem Wasserstoff gebildet ist.

## Revendications

1. Dispositif à semiconducteur avec une fonction de protection contre les surtensions, comprenant:
- une première couche de semiconducteur (21) d'un premier type de conductibilité;
- une deuxième couche de semiconducteur (22) d'un deuxième type de conductibilité formée sur ladite première couche de semiconducteur (21) et une troisième couche de semiconducteur (23) dudit premier type de conductibilité formé sur ladite deuxième couche de semiconducteur (22),
dans lequel ledit dispositif à semiconducteur comporte un élément formant dispositif principal (TM) ayant un chemin de courant principal du dispositif, l'élément formant dispositif principal (TM) comprenant une première partie desdites première, deuxième et troisième couches de semiconducteur (21, 22, 23) et un élément formant dispositif auxiliaire (TP) comprenant une deuxième partie de deux couches quelconques parmi lesdites première, deuxième et troisième couches de semiconducteur (21, 22, 23) en dehors dudit chemin de courant principal, ladite deuxième partie étant exclue de ladite première partie,
caractérisé en ce que:
- une couche à haute densité de défauts cristallins est formée uniquement dans une zone dudit élément formant dispositif auxiliaire (TP), dans laquelle une couche de déplétion (25) est formée lorsqu'une tension inverse spécifiée est appliquée à une jonction PN (31) formée entre lesdites deux couches voisines (22, 23) dans ledit élément formant dispositif auxiliaire (TP); et
- ledit élément formant dispositif auxiliaire (TP) est claqué avant ledit élément formant dispositif principal (TM) du fait de ladite couche à haute densité de défauts cristallins (100) quand une surtrension est appliquée audit dispositif à semiconducteur.

2. Dispositif à semiconducteur selon la revendication 1, caractérisé en ce que ledit élément formant dispositif principal (TM) est rendu conducteur par un courant de claquage produit lorsque ledit élément formant dispositif auxiliaire (TP) est claqué.

3. Dispositif à semiconducteur selon la revendication 1 ou 2, caractérisé en ce que lesdites deux couches voisines sont lesdites deuxième et troisième couches de semiconducteur (22, 23), et ladite couche à haute densité de défauts cristallins est formée uniquement dans une zone de ladite deuxième couche de semiconducteur (22) dans ledit élément formant dispositif auxiliaire (TP), dans lequel une couche de déplétion est formée lorsqu'une tension inverse spécifiée est appliquée à une jonction PN (31) formée entre lesdites deuxième et troisième couches de semiconducteur (22, 23) dans ledit élément formant dispositif auxiliaire (TP).

4. Dispositif à semiconducteur selon la revendication 3, caractérisé en ce que ledit élément formant dispositif auxiliaire (TP) comprend en outre une deuxième partie de ladite première couche de semiconducteur (21) hors de ladite première partie.

5. Dispositif à semiconducteur selon la revendication 1, 2 ou 4, caractérisé en ce que ledit élément formant dispositif principal (TM) comprend en outre une quatrième couche de semiconducteur (24a) dudit deuxième type de conductibilité formée sur ladite troisième couche de semiconducteur (23), et ladite quatrième couche de semiconducteur (24a) n'est pas formée au-dessus de ladite couche à haute densité de défauts cristallins (100).

6. Dispositif à semiconducteur selon la revendication 5, caractérisé en ce que ledit élément formant dispositif principal (TM) est constitué par un thyristor.

7. Dispositif à semiconducteur selon la revendication 6, caractérisé en ce que ledit dispositif auxiliaire (TP) comporte une région de grille (38) formée sur ladite troisième couche de semiconducteur (23).

8. Dispositif à semiconducteur selon la revendication 7, caractérisé en ce que ladite région de grille comprend une surface d'irradiation par une lumière de déclenchement (38) qui est la surface exposée de ladite troisième couche de semiconducteur (22).

9. Dispositif à semiconducteur selon la revendication 8, caractérisé en ce que ladite surface d'irradiation par une lumière de déclenchement (38) comprend un renfoncement (30) formé dans la troisième couche de semiconducteur (23).

10. Dispositif à semiconducteur selon la revendication 7, caractérisé en ce que ladite région de grille comprend une électrode de grille (48c) en contact avec ladite troisième couche de semiconducteur (43).

11. Dispositif à semiconducteur selon l'une quelconque des revendications 1 à 10, caractérisé en ce que ladite couche à haute densité de défauts cristallins (100) est formée en travers de ladite jonction PN (31) entre lesdites deux couches voisines dans ledit élément formant dispositif auxiliaire.

12. Dispositif à semiconducteur selon l'une quelconque des revendications 7 à 10, caractérisé en ce que ladite couche à haute densité de défauts cristallins est une couche en forme d'anneau (100) ayant une ouverture directement sous ladite région de grille.

13. Dispositif à semiconducteur selon l'une quelconque des revendications 1 à 5, caractérisé en ce que ledit élément formant dispositif principal est constitué par un transistor.

14. Dispositif à semiconducteur selon la revendication 1, 2 ou 3, caractérisé en ce que ledit élément formant dispositif auxiliaire est constitué par une diode.

15. Procédé de fabrication d'un dispositif à semiconducteur selon l'une quelconque des revendications 1 à 14, caractérisé en ce que ladite couche à haute densité de défauts cristallins (100) est formée par irradiation avec un faisceau, et une tension de claquage dudit élément formant dispositif auxiliaire est commandée par la valeur de la dose de ladite irradiation.

16. Procédé selon la revendication 15, caractérisé en ce que le procédé d'irradiation avec ledit faisceau est exécuté à la fin de la fabrication du dispositif à semiconducteur.

17. Procédé selon la revendication 15, caractérisé en ce que ledit faisceau est sélectionnné parmi un groupe comprenant le proton, l'hélium et l'hydrogène lourd.
